(19) Europäisches Patentamt
European Patent Office
Office européen des brevets

(11) **EP 2 568 601 A1**

(12) **EUROPEAN PATENT APPLICATION**

(43) Date of publication:
**13.03.2013 Bulletin 2013/11**

(51) Int Cl.:
***H03G 3/00*** *(2006.01)*

(21) Application number: **11306124.6**

(22) Date of filing: **09.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ST-Ericsson SA**
**1228 Plan-les-Ouates (CH)**

(72) Inventors:
• **Lenz, Kuno**
**38340 VOREPPE (FR)**

• **Chianale, Alain**
**38120 SAINT EGREVE (FR)**
• **Perrin, Danika**
**38560 JARRIE (FR)**
• **Sirito-Olivier, Philippe**
**38120 SAINT EGREVE (FR)**

(74) Representative: **Cabinet Plasseraud**
**52, rue de la Victoire**
**75440 Paris Cedex 09 (FR)**

(54) **AGC with double slope**

(57)    There is described a method for controlling the gain on an amplifier present on a circuit comprising at least : a power supply, such as a battery, wherein the power supply voltage decreases over time,- an amplifier outputting an output signal; and, an automatic gain control for controlling the gain of the amplifier. The method comprises : a step of monitoring the supply voltage and, as the supply voltage is comprised between a first supply voltage threshold and a second supply voltage threshold, smaller than the first supply voltage threshold, controlling the gain of the amplifier so that a maximal amplitude of the output signal decreases as the supply voltage decreases.

A third supply voltage threshold is comprised between the first and second supply voltage thresholds, the maximal amplitude allowed diminishing with the supply voltage decreasing according to a first function for supply voltages comprised between the first supply voltage threshold and the third supply voltage threshold, and the maximal amplitude allowed diminishing with the supply voltage decreasing according to a second function for supply voltages comprised between the second supply voltage threshold and the third supply voltage threshold. In addition, the first function has a slope which is smaller, in absolute value, than a slope of the second function at the third voltage threshold.

FIG. 4

Printed by Jouve, 75001 PARIS (FR)

**Description**

**BACKGROUND**

**Technical Field**

The present invention generally relates to techniques for controlling a signal amplifier in portable devices powered with a battery. It finds application, in particular, in electronic devices comprising an audio circuit such as mobile phones, mobile computers, digital personal assistants (PDA), digital audio players and other such mobile devices.

**Related Art**

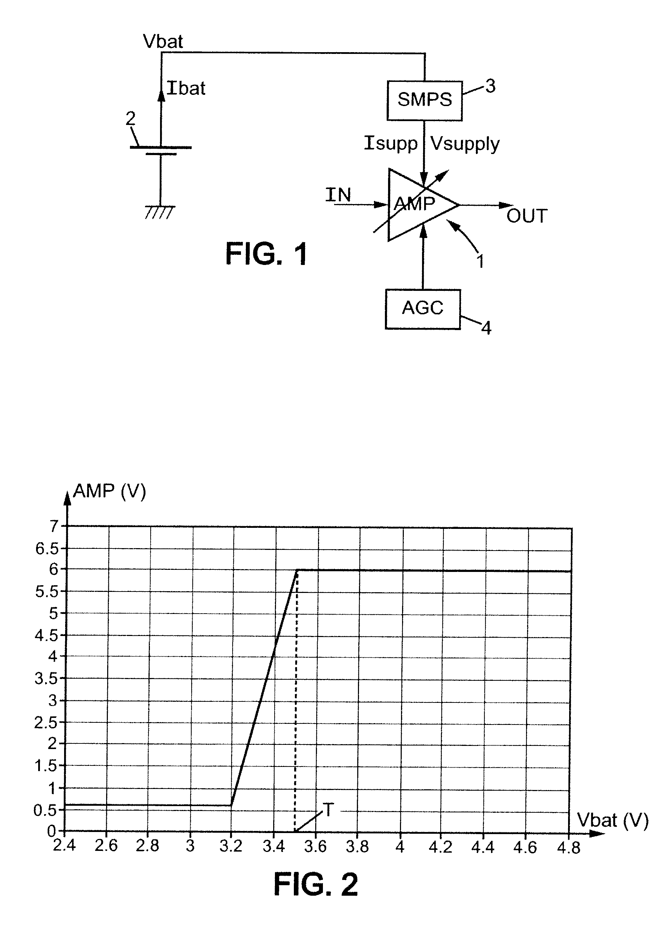

An audio amplification circuit in a portable device comprises generally an audio amplifier 1 supplied by a power supply such as a battery 2 (Figure 1). The audio amplifier 1 receives an input signal by an input terminal IN and outputs an amplified output signal through an output OUT. The output signal is adapted to drive at least one speaker or ear set.
The music loudness increases when the audio amplifier's output current increases. The amplifier's output current is proportional to its output voltage amplitude. The amplitude may be higher than the battery voltage. In those cases the supply voltage may be boosted by a Switched Mode Power Supply 3 (SMPS).
A SMPS conserves the power consumption in a first order approximation, i.e. the product of the current supplied to the amplifier by the SMPS and the voltage supplied by the SMPS to the amplifier is equal to the product of the current supplied to the SMPS and the voltage supplied by the battery to the SMPS as per equation 1 below:

$$\text{Isupply x Vsupply} = \text{Ibat x Vbat.} \qquad (equation\ 1)$$

As the input signal has an amplitude that varies over time to produce a sound signal, the amplified output signal also has an amplitude that varies with time.
The SMPS supplies a constant voltage to the amplifier. Accordingly, as the amplitude of the output signal varies, and the supply voltage is constant, the current supplied to the amplifier varies. Therefore, the battery current supplying the amplifier through the SMPS varies together with the amplitude of the output signal.
However, as the battery supplies power, the battery voltage diminishes with time.
Therefore, in order to compensate for the battery voltage reduction, the battery current delivered by the battery to the SMPS increases as the battery voltage decreases.
As the battery voltage decreases, a first voltage threshold may be reached for which, in order to provide enough power to the amplifier, the battery current would often need to exceed a maximal capability current value corresponding to a limit of the battery capability. However, a battery current higher than the maximal capability current may lead to a sudden battery voltage drop which can generate unpredictable reset of the portable device. Accordingly, it is preferable to avoid a too high battery current.
Therefore, before the battery current supplied by the battery exceeds the maximum capability current, the circuits may be designed so as to reduce drastically the power consumed by the amplifier.
Accordingly, the gain of the audio amplifier as a function of the battery voltage may decrease drastically once a first battery voltage threshold is met. Thus, as the gain is reduced, the amplitude of the output signal is reduced and the power needed for performing the amplification is reduced. As a consequence, the audio amplifier needs less current from the battery.
The reason for the above mentioned drastic decrease in the gain of the audio voltage battery is that, as the battery voltage reaches some very low values, its maximal capability current may also start decreasing. A slow reduction of the gain over all the battery voltage range, for instance with only one slope as in the prior art, would not be sufficient.
In most cases, the first voltage threshold is generally a voltage threshold measured for the value of the battery voltage.
The reduction of the gain as a function of the battery voltage may be obtained by using an Automatic Gain Control (AGC) 4.
In some embodiments the AGC 4 monitors an amplitude of the amplified output signal and compares it to a maximal amplitude allowed, which may vary as a function of the battery voltage.
When the amplitude of the outputted signal reaches the maximal amplitude allowed, the gain is reduced so that the amplitude of the outputted signal stays under the value of the maximal amplitude allowed.
The amplified output signal may be modulated in amplitude. Therefore some parts of the signal may comprise bigger amplitudes than some other parts of the signal. Accordingly, each time the amplified output signal's amplitude becomes greater than the maximal amplitude allowed, the AGC reduces the gain of the amplifier.

Figure 2 shows an example of a curve according to which the AGC controls the amplifier's gain. As the battery voltage is reduced (in abscise), the maximal amplitude allowed AMP (in ordinate) is fixed at a constant value until the battery voltage reaches a given threshold T. In this illustrative example, the threshold T is set at 3.5 V and the maximal amplitude allowed is set to 6 V.

As the battery voltage diminishes under said threshold T, the AGC is programmed to reduce the gain of amplifier so that the maximal amplitude allowed diminishes at a fixed rate as a function of the battery voltage reduction.

The relation between the maximal amplitude allowed and the battery voltage may generally be described, at the first order, as a steep slope. In the illustrative example of figure 2, the maximal amplitude allowed goes from 6 V to less than 0.5 V while the battery voltage diminishes from 3.5 V to 3.2 V.

This way, as the amplitude of the audio signal outputted by the audio amplifier is reduced at the same time that the battery current risks to reach the limits of the battery capability, sudden battery drops are avoided. Therefore other components of the portable device may still be supplied with power and undesired resets of the device are avoided.

However, while enabling to avoid sudden battery drops, this solution is not satisfactory for a customer using the portable device. The drastic reduction of the maximal amplitude allowed for the output signal leads to a high reduction of the sound loudness. Indeed, as the battery voltage reaches the threshold T, the customer using the portable device perceives a sound loudness that diminishes as the time passes.

Therefore, there is a need for improved methods for controlling the gain of audio amplifiers in portable audio devices.

## SUMMARY

To address these needs, a first aspect of the present invention proposes a new set of instructions for the AGC. In particular the first aspect of the invention relates to a method for controlling the gain on an amplifier present in a circuit. The circuit comprises at least :

- a power supply, such as battery, configured to provide a supply voltage and a supply current, wherein the power supply has operating phases during which the supply voltage decreases over time,

- an amplifier outputting an output signal, and,

- an automatic gain control, AGC, unit configured to control the gain of the amplifier.

In embodiments, the method comprises:

- a step of monitoring the supply voltage and,

- as the supply voltage is comprised between a first supply voltage threshold and a second supply voltage threshold, smaller than the first supply voltage threshold, controlling the gain of the amplifier so that a maximal amplitude of the output signal decreases as the supply voltage decreases.

Further, a third supply voltage threshold may be comprised between the first and second supply voltage thresholds. The maximal amplitude allowed diminishing with the supply voltage decreases according to a first function for supply voltages comprised between the first supply voltage threshold and the third supply voltage threshold, and it decreases according to a second function for supply voltages comprised between the second supply voltage threshold and the third supply voltage threshold. Further, the first function has a slope which is smaller, in absolute value, than a slope of the second function at the third voltage threshold.

Thus, for supply voltages closer to the first supply voltage threshold, the method enables to have a slower decrease of the value of the maximum amplitude allowed compared with the known control methods.

Thus, for supply voltages smaller than the first threshold, user perceives a louder sound for an audio signal of a device which implements the method than for other known devices.

The first function may be a rectilinear function which has a slope smaller than a slope of the second function near the third supply voltage threshold.

Advantageously, the first supply voltage threshold may be a supply voltage value for which the current supplied to the amplifier reaches a supply current limit value. Accordingly, the gain of the amplifier is reduced for any supply voltages for which the supply current would be greater than said supply current limit value if no reduction of the maximum amplitude allowed were to be enabled.

In an advantageous embodiment, the first function is chosen so that the supply current supplied to the amplifier is close to the supply current limit value as the supply voltage is comprised between the first and third supply voltage thresholds. Indeed, one reasoning behind the invention was that there is a supply voltage range for which the battery current, without reduction of the maximum amplitude allowed, would be greater than the supply current limit, but for which the power supply may still output some power that may be used by the amplifier. Thus, the first function may advantageously be designed so that the amplifier uses, between the first and third supply voltage thresholds, a battery current that is as close as possible to the supply current limit. This enables the consumer to perceive the loudest sound possible for any given value of the supply voltage.

In most cases, the supply current is capable of outputting a maximal capability current as a function of the supply voltage. The maximal capability current decreases as the supply voltages get smaller than a fourthsupply voltage threshold. It may further be roughly constant as the supply voltage is greater than said fourth supply voltage threshold.

Further, the supply current limit may advantageously be chosen based on the value of the maximal capability current for supply voltages superior to the first supply threshold.

Further, the second function may be chosen so that the current supplied to the amplifier is smaller than a given ratio of the maximal supply current for each supply voltage value inferior to the third supply voltage threshold.

Thus a security margin regarding the supply current may be provided for the device. Other methods may be used in order to perform this function.

Further, the third supply voltage threshold may be chosen so as to correspond to the fourth battery voltage threshold. Thus, as the battery voltage decreases, the maximum amplitude allowed decreases according to the first function until the fourth battery voltage threshold is reached, meaning that the capability of the battery decreases. Thus, the gain of the amplifier is always maintained at the maximal value possible depending on the maximal battery current and on the battery voltage under which the battery capability decreases.

The device comprises a Switched Mode Power Supply (SMPS), the power supply supplying the SMPS which in turns provides the amplifier with a constant input voltage.

There is also proposed a computer program product comprising one or more stored sequences of instructions that are accessible to a processor and which, when executed by the processor, cause the processor to carry out the steps of the above method. Indeed, the function of the AGC may be enacted by a processor.

There is further proposed an audio circuit comprising:

- a power supply, such as a battery, configured to provide a supply voltage and a supply current, wherein the power supply have phases during which the supply voltage decreases over time,

- an amplifier arranged to output an output signal, and,

- an automatic gain control, AGC, unit configured to control the gain of the amplifier.

The AGC unit is further configured to monitor an amplitude of the output signal, to monitor the supply voltage, to determine a maximal amplitude allowed based on an amplitude of the output signal, to compare the amplitude of the output signal to the maximal amplitude allowed and to control the gain of the amplifier in order to maintain the amplitude of the output signal under the maximal amplitude allowed.

The AGC unit is further programmed with a given supply voltage-maximal amplitude allowed curve, the curve comprising, for battery voltages comprised between a first supply voltage threshold and a second supply voltage threshold, smaller than the first supply voltage threshold, a maximal amplitude allowed decreasing as a function of the supply voltage.

A third supply voltage threshold is comprised between the first and second supply voltage thresholds; the maximal amplitude allowed diminishing with the supply voltage decreasing according to a first function for supply voltages comprised between the first supply voltage threshold and the third supply voltage threshold, and the maximal amplitude allowed diminishing with the supply voltage decreasing according to a second function for supply voltages comprised between the second supply voltage threshold and the third supply voltage threshold.

Further, the first function has a slope which is smaller, in absolute value, than a slope of the second function at the third supply threshold.

This audio device is a device that is configured to adapt the gain of the amplifier to the capability of the power supply in a most efficient way, enabling the amplifier to draw as much power as the power supply may provide for any value of the supply voltage. Compared to the known method for matching the maximum allowed amplitude to the supply voltage, the control of the amplifier by the AGC may be more adjusted to the capability of the power supply.

A fourth aspect of the present invention relates to a mobile device comprising an audio circuit as described above.

**BRIEF DESCRIPTION OF THE DRAWINGS**

Embodiments of the present invention are illustrated by way of example, and not by way of limitation, in the figures of the accompanying drawings, in which like reference numerals refer to similar elements and in which:

- Figure 1 is a schematic view of an audio amplification circuit in a portable device,

- Figure 2 is an illustrative example of a curve according to which the AGC controls the amplifier's gain according to known techniques,

- Figure 3 is a flow chart illustrating steps of a method for controlling an amplifier using an amplifier gain control according to the invention,

- Figure 4 is an illustrative example of a curve according to which the AGC controls the amplifier's gain according to the invention, comprising at least two decreasing slopes as the battery voltage decreases,

- Figure 5 is an illustrative example of a curve according to which the AGC controls the amplifier's gain according to known techniques describing evolutions of the battery current as a function of the battery voltage.

## DESCRIPTION OF PREFERRED EMBODIMENTS

The present invention concerns a method for controlling an amplifier using an amplifier gain control (AGC).

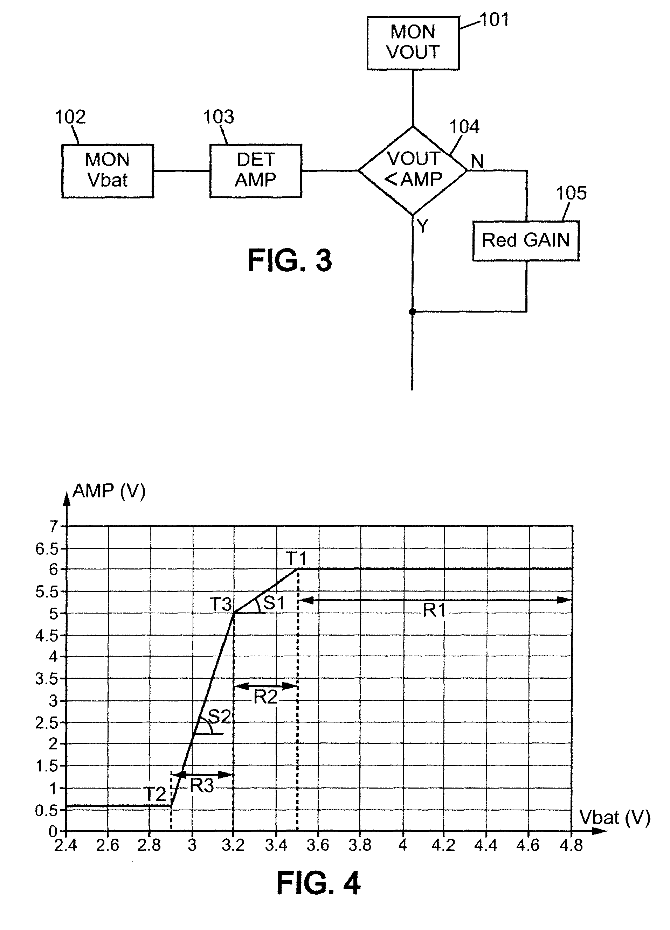

According to an embodiment of the invention, illustrated with reference to figure 3, the method comprises a step 101 of monitoring a voltage amplitude of a signal outputted by an amplifier. Further the method comprises a step 102 of monitoring a power supply voltage supplied by a power supply to the amplifier. The power supply may be, for instance, a battery (chemical device), a super-cap (i.e., a big capacitor), a power charger (e.g., a 110V or 220V wall plug charger, or USB charger, or any charger between a power source (solar, wind, etc.) and the mobile device), etc. All these devices have the same behavior: output voltage decreases if too much current has to be supplied.

Then a maximal amplitude allowed, which is function of the battery voltage, is determined (step 103).

In a step 104, the voltage amplitude of the signal outputted by the amplifier is compared to the maximal amplitude allowed. If the comparison shows that the amplifier outputs an output signal of amplitude greater than the maximal amplitude allowed, the gain of the amplifier is reduced (step 105).

According to an embodiment of the invention the function for calculating the maximal amplitude allowed to the battery voltage is as bellow:

- in a first voltage range R1 of the battery voltage, for voltages higher than a first voltage threshold T1, the maximal amplitude allowed AMP is roughly constant (figure 4),

- for voltages comprised between a second voltage threshold T2, smaller than the first voltage threshold and the first voltage threshold T1, the maximal amplitude allowed decreases when the battery voltage decreases.

Further, the range comprised between the second voltage threshold T2 and the first voltage threshold T1 comprises a third voltage threshold T3:

- for a second voltage range R2, for battery voltages comprised between the first voltage threshold T1 and the third voltage threshold T3, the maximal amplitude allowed decreases when the battery voltage decreases according to a first function, e.g. a first slope S1 if the first function is rectilinear, and,

- for a third voltage range R3, comprised between the second voltage threshold T2 and third voltage threshold T3, the maximal amplitude allowed decreases with a second function with the decrease of the battery voltage. In the example described hereby, the second function is a rectilinear function having a second slope S2.

According to this embodiment of the invention, the second slope is steeper than the first slope.

In case of high amplitude of the output signal, the amplitude of the output signal may reach the maximal amplitude allowed. In such case, the battery current That supplied by the battery to the amplifier reaches a high value. Thereafter, the expression "battery current Ibat" will refer to said high value.

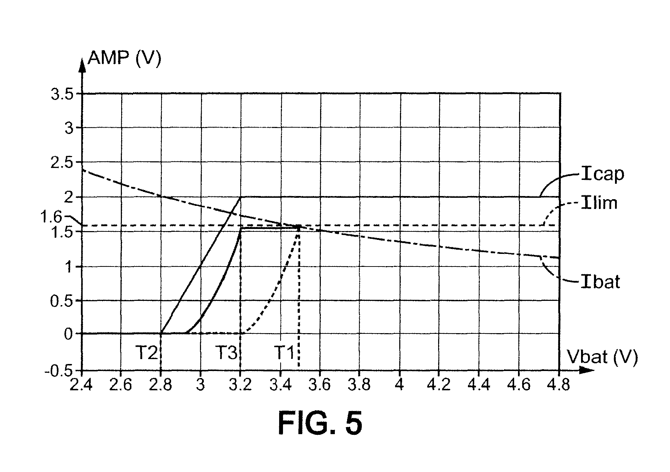

Thus, as the battery voltage decreases due to a reduction of charges in the battery, the battery current Ibat increases until it reaches a battery current limit Ilim (Figure 5). The battery voltage corresponding to the battery current reaching the battery current limit Ilim defines the first voltage threshold which is the minimal value of the first voltage range. In this illustrative example, Ilim is fixed to a 80% ratio of a maximal capability current Icap and the first voltage threshold is close to 3.5 V. The maximal capability current Icap corresponds to a maximum current that the battery can deliver when it operates at maximal capability.

The maximal capability current is defined as a maximal current that the battery is able to output for a given battery voltage without going over the battery capability. The maximal capability current may vary as a function of the battery voltage. In this illustrative example, the maximal capability current has a value of roughly 2 A for battery voltages superior to 3.2 V.

The difference between the maximal capability current Icap and the maximal battery current limit Ilim defines a security margin. The security margin may be defined as a ratio of the maximal capability current Icap or as a given amperage value. The security margin may vary from device to device.

Further, according to some implementations of steps 103 of determining the maximal amplitude allowed, the first and third thresholds may coincide. In this case, the AGC controls the gain of the amplifier using only the first voltage range and the slope of the third voltage range as defined above.

Conversely, according to the determination step of the present embodiment, suitable for battery voltages comprised between the first voltage threshold and the third voltage threshold, the gain of the amplifier is adapted so that the battery current Ibat is close to the battery current limit Ilim as the voltage decreases. In some embodiments, the gain of the amplifier is controlled so that the battery current Ibat is equal to the battery current limit as the battery voltage decreases. In other embodiments, the gain of the amplifier is controlled so that the battery current Ibat is strictly inferior to the battery current limit as the battery voltage decreases while being close to the battery current limit.

As the battery voltages decreases further, it reaches the third threshold T3 and is in the third range. Advantageously, the third threshold may be chosen as corresponding to a battery voltage for which the maximal capability current drops as a function of the decrease of the battery voltage. Accordingly, in embodiments of the invention, for battery voltages inferior to the third threshold, the gain of the amplifier diminishes with the decrease of maximal capability current as a second function of the battery voltage. The second function follows the second slope described above. In some cases, the second slope may be close to the slope used by state of the art AGC.

In other words, in some embodiments, the third range is a range of the battery voltage wherein the maximal battery current is roughly at maximal value and wherein the battery current would be higher than the maximal battery current, or the battery current limit, if no reduction of the amplifier's gain were applied by the AGC.

Further, the third range may be defined as a voltage range for which the battery capability decreases with a reduction of the battery voltage.

In some cases, the security margin may be chosen as a ratio of the maximal capability current. The gain, in the third range, may then be reduced so that the battery current Ibat follows the decrease of the maximal capability current corrected by said ratio.

Alternatively, the security margin may be chosen as a constant amperage under the maximal capability current. The gain, in the third range, may then be reduced so that the battery current Ibat follows the decrease of the maximal capability current minus said security margin.

Alternatively the second function may be so that the maximal battery current, for an output signal of maximal amplitude, follows a steeper decrease than the decrease of the maximal capability current. Such situation is illustrated in Figure 5.

In a further embodiment, the amplitude of the signal outputted by the amplifier may be monitored and registered to determine a maximal outputted amplitude. When the outputted amplitude becomes greater than the maximal outputted amplitude value previously stored, the maximal outputted amplitude is updated to said outputted amplitude.

In this embodiment if the stored value of the maximal outputted amplitude is inferior the maximal allowed amplitude for a given duration, the gain is increase by a given increment.

As the gain is changed, either through an increase of a given increment or due to the amplitude of the output signal becoming superior to the maximal amplitude allowed, the maximal outputted amplitude may be reset.

The given duration may be of some microseconds up to some few hundreds microseconds e.g. every 20 μs or every 100 μs or every 200 μs depending on the system parameters.

The invention is also related to a device for audio amplification, especially in mobile devices.

Such a device is mostly, for its outside appearance, close to the devices known to the person skilled in the art illustrated with respect to figure 1. However, it at least differs in that its AGC is programmed differently. The AGC comprises a reference to the curve mentioned above and illustrated in figure 4.

In some embodiments, the AGC may have connections to both the battery 2 and to the output OUT.

Further, the AGC may have input means for modifying multiple parameters such as the values of the first, second and third thresholds, and/or the values of the battery current limit, the first slope and the second slope.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

While there has been illustrated and described what are presently considered to be the preferred embodiments of the present invention, it will be understood by those skilled in the art that various other modifications may be made, and equivalents may be substituted, without departing from the true scope of the present invention.

For instance, embodiments may comprise monitoring the supply current (e.g., battery current) instead of the supply voltage (e.g., battery voltage). Practical implementations are more complex, but yet possible. Thus, the terms "voltage" and "current" in the description and claims must be broadly interpreted, having in mind the voltage/current equivalence which is well known to the one with ordinary skills in the art.

Additionally, many modifications may be made to adapt a particular situation to the teachings of the present invention without departing from the central inventive concept described herein. Furthermore, an embodiment of the present invention may not include all of the features described above. Therefore, it is intended that the present invention not be limited to the particular embodiments disclosed, but that the invention include all embodiments falling within the scope of the appended claims.

A person skilled in the art will readily appreciate that various parameters disclosed in the description may be modified and that various embodiments disclosed and/or claimed may be combined without departing from the scope of the invention.

It is stipulated that the reference signs in the claims do not limit the scope of the claims, but are merely inserted to enhance the legibility of the claims.

**Claims**

1. Method for controlling the gain on an amplifier present on a circuit, wherein the circuit further comprises at least :

    - a power supply, configured to provide a supply voltage and a supply current, wherein the power supply has operating phases during which the supply voltage decreases over time,
    - an amplifier outputting an output signal, and,
    - an automatic gain control, AGC, unit configured to control the gain of the amplifier,

    the method comprising:

    - a step of monitoring the supply voltage and,
    - as the supply voltage is comprised between a first supply voltage threshold and a second supply voltage threshold, smaller than the first battery supply threshold, controlling the gain of the amplifier so that a maximal amplitude of the output signal decreases as the supply voltage decreases,

    wherein a third supply voltage threshold is comprised between the first and second supply voltage thresholds, the maximal amplitude allowed diminishing with the supply voltage decreasing according to a first function for supply voltages comprised between the first supply voltage threshold and the third supply voltage threshold, and the maximal amplitude allowed diminishing with the supply voltage decreasing according to a second function for supply voltages comprised between the second supply voltage threshold and the third supply voltage threshold,
    wherein the first function has a slope which is smaller, in absolute value, than a slope of the second function at the third supply threshold.

2. The Method of claim 1, wherein the first function is a rectilinear function which has a slope smaller than a slope of the second function near the third supply voltage threshold.

3. The Method of any of claims 1 or 2, wherein the first supply voltage threshold is a supply voltage value for which the current supplied to the amplifier reaches a supply current limit value.

4. The Method of claim 3, wherein the first function is chosen so that the supply current supplied to the amplifier is close to the supply current limit value as the supply voltage is comprised between the first and third supply voltage thresholds.

5. The Method of claim 3 or 4, wherein the supply current is capable of outputting a maximal capability current as a function of the supply voltage; said maximal capability current decreasing as the supply voltages get smaller than a fourth battery voltage threshold and being roughly constant as the supply voltage is greater than said fourth supply voltage threshold, and wherein the supply current limit is chosen based on the value of the maximal capability current for supply voltages superior to the first voltage threshold.

6. The Method of any of claims 1 to 5, wherein the supply current is capable of outputting a maximal capability current as a function of the supply voltage; said maximal capability current decreasing as the supply voltages get smaller than a fourth supply voltage threshold and being roughly constant as the supply voltage is greater than said fourth supply voltage threshold, and wherein the second function is chosen so that the current supplied to the amplifier is smaller than a given ratio of the maximal supply current for each supply voltage value inferior to the third battery voltage threshold.

7. The Method of any of claims 1 to 6, wherein the supply current is capable of outputting a maximal capability current as a function of the supply voltage; said maximal capability current decreasing as the supply voltages get smaller than a supply battery voltage threshold and being roughly constant as the supply voltage is greater than said fourth supply voltage threshold, and wherein the third supply voltage threshold is chosen so as to correspond to the fourth supply voltage threshold.

8. The Method of any of claims 1 to 7, wherein the device comprises a Switched Mode Power Supply (3), SMPS, the supply supplying the SMPS which in turns provides the amplifier with a constant input voltage.

9. An audio circuit comprising:

- -a power supply, configured to provide a supply voltage and a supply current, wherein the power supply has operating phases during which the supply voltage decreases over time,
-an amplifier arranged to output an output signal, and,
-an automatic gain control, AGC, unit configured to control the gain of the amplifier,

the AGC unit being further configured to monitor an amplitude of the output signal, the AGC unit being further configured to monitor the supply voltage,
the AGC unit being further configured to determine a maximal amplitude allowed based on an amplitude of the output signal,
the AGC unit being further configured to compare the amplitude of the output signal to the maximal amplitude allowed,
the AGC unit being further configured to control the gain of the amplifier in order to maintain the amplitude of the output signal under the maximal amplitude allowed,
wherein the AGC unit is further programmed with a given supply voltage-maximal amplitude allowed curve, the curve comprising, for supply voltages comprised between a first supply voltage threshold and a second supply voltage threshold, smaller than the first supply voltage threshold, a maximal amplitude allowed decreasing as a function of the supply voltage,
wherein a third supply voltage threshold is comprised between the first and second battery supply thresholds; the maximal amplitude allowed diminishing with the supply voltage decreasing according to a first function for supply voltages comprised between the first supply voltage threshold and the third supply voltage threshold, and the maximal amplitude allowed diminishing with the supply voltage decreasing according to a second function for supply voltages comprised between the second supply voltage threshold and the third supply voltage threshold,
wherein the first function has a slope which is smaller, in absolute value, than a slope of the second function at the third voltage threshold.

10. A Mobile device comprising an audio circuit with an amplifier controlled according to the method of any of claims 1 to 8.

FIG. 1

FIG. 2

FIG. 3

FIG. 4

FIG. 5

EP 2 568 601 A1

Europäisches
Patentamt
European
Patent Office
Office européen
des brevets

# EUROPEAN SEARCH REPORT

Application Number

EP 11 30 6124

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/100179 A1 (BEHBOODIAN ALI [US] ET AL) 12 May 2005 (2005-05-12) * paragraph [0006] - paragraph [0007] * * paragraph [0020] - paragraph [0028]; figures * ----- | 1-10 | INV. H03G3/00 |
| X | US 2006/247920 A1 (TORIYAMA KOJI [JP]) 2 November 2006 (2006-11-02) * paragraph [0055] - paragraph [0061] * * paragraph [0133] - paragraph [0142]; figures 1,2,16 * ----- | 1,9,10 | |

TECHNICAL FIELDS SEARCHED (IPC)

H03G

The present search report has been drawn up for all claims

| Place of search | Date of completion of the search | Examiner |
|---|---|---|
| The Hague | 12 January 2012 | Blaas, Dirk-Lütjen |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 30 6124

This annex lists the patent family members relating to the patent documents cited in the above-mentioned European search report.
The members are as contained in the European Patent Office EDP file on
The European Patent Office is in no way liable for these particulars which are merely given for the purpose of information.

12-01-2012

| Patent document cited in search report | Publication date | Patent family member(s) | Publication date |
|---|---|---|---|
| US 2005100179 A1 | 12-05-2005 | AU 2004310375 A1 | 26-05-2005 |
| | | CN 1879297 A | 13-12-2006 |
| | | EP 1683391 A2 | 26-07-2006 |
| | | JP 2007512733 A | 17-05-2007 |
| | | KR 20060086380 A | 31-07-2006 |
| | | US 2005100179 A1 | 12-05-2005 |
| | | WO 2005048644 A2 | 26-05-2005 |
| US 2006247920 A1 | 02-11-2006 | CN 101138152 A | 05-03-2008 |
| | | JP 2006311382 A | 09-11-2006 |
| | | TW I335726 B | 01-01-2011 |
| | | US 2006247920 A1 | 02-11-2006 |
| | | WO 2006118292 A1 | 09-11-2006 |

EPO FORM P0459

For more details about this annex : see Official Journal of the European Patent Office, No. 12/82